# EUROPÄISCHE PATENTSCHRIFT

(11) **EP 0 445 664 B1**
(45) Veröffentlichungstag und Bekanntmachung des Hinweises auf die Patenterteilung: **28.12.1994**
(21) Anmeldenummer: 91103089.8
(22) Anmeldetag: 01.03.1991
(51) Int. Cl.: H03D 1/22, H04N 5/60

(54) **Schaltungsanordnung zum Detektieren von Kennschwingungen**
Circuit arrangement for detecting identification signals
Circuit de détection d'oscillations caractéristiques

(30) Priorität: 03.03.1990 DE 4006654
(43) Veröffentlichungstag der Anmeldung: 11.09.1991
(73) Patentinhaber: Philips Patentverwaltung GmbH, 22335 Hamburg (DE); Philips Electronics N.V., 5621 BA Eindhoven (NL)
(72) Erfinder: Kühn, Hans-Jürgen, W-2110 Buchholz (DE)
(74) Vertreter: Peters, Carl Heinrich, Dipl.-Ing.

(56) Entgegenhaltungen:
- EP-A- 0 316 878
- DE-A- 3 411 259
- PATENT ABSTRACTS OF JAPAN vol. 4, no. 145 (E-29)(627) 14. Oktober 1980 & JP-A-55 95 474 (SANYO DENKI K.K. ) 19. Juli 1980
- FUNKSCHAU Nr. 2, 1982, MUNCHEN Seiten 76 - 79; KLAUS-DIETER KUMMEL: 'ZWEI-KANAL-FERNSEHTON '
- IEEE TRANSACTIONS ON CONSUMER ELECTRONICS Bd. CE-30, Nr. 3, August 1984, NEW YORK Seiten 302 - 311; GUIDO TORELLI ET AL.: 'DEVELOPING A CMOS SINGLE-CHIP STEREO DECODER AND AUDIO PROCESSOR FOR DUAL CHANNEL TV '

## Beschreibung

Die Erfindung bezieht sich auf eine Schaltungsanordnung zum Detektieren von Kennschwingungen gemäß dem Oberbegriff des Hauptanspruchs.

Eine derartige Schaltungsanordnung ist aus der JP-A-55-95 474 bekannt. Darin wird ein "control channel signal" nach einer Amplitudendemodulation und einer Tiefpaßfilterung als "control signal" mit einer ersten oder einer zweiten Frequenz parallel zwei PLL-Schaltungen zugeführt. Wenn das "control signal" eine erste Frequenz aufweist, gibt die erste PLL-Schaltung ein Signal ab; weist dagegen das "control signal" eine zweite Frequenz auf, gibt die zweite PLL-Schaltung ein Signal ab. Beide PLL-Schaltungen sind als analoge PLL-Schaltungen aufgebaut. Die von ihnen abgegebenen Signale werden in einem Komparator verglichen; entsprechend dem Ergebnis dieses Vergleichs wird eine LED-Anzeige und ein Dekoder auf "Zweikanal"- oder "Stereo"-Betrieb eingestellt.

Aus "IEEE Transactions on Consumer Electronics", Band CE-31, Nr. 3, August 1985, Seiten 461 bis 467, sind Stereodecoder für Fernseh- und Rundfunkempfänger in Schalterkondensatortechnik bekannt, die einen Identifikationszweig aufweisen zum Identifizieren der übertragungsart "Zweikanal" oder "Stereo". Dieser Identifikationszweig umfaßt ein kontinuierlich arbeitendes Tiefpaßfilter zum Unterdrücken von Signalkomponenten, die bei nachfolgenden Mischvorgängen Störungen im Nutzsignal hervorrufen könnten, sowie - in Schalterkondensatortechnik - ein Pilotträgerfilter, das als Hochpaßfilter ausgebildet ist, die Toninformation unterdrückt und den Pilotträger verstärkt. Dem ist ein AM-Detektor und ein Tiefpaßfilter nachgeschaltet. Mit dem Ausgang des Tiefpaßfilters sind zwei Identifikationsfilter für die Frequenzen 117,5 Hz und 274,1 Hz verbunden. Die Ausgangspegel dieser Filter werden mit Hilfe von Spitzenwertdetektoren und Tiefpaßfiltern erster Ordnung detektiert. Über Komparatoren werden die Ausgangssignale der Tiefpaßfilter erster Ordnung in für eine nachfolgende digitale Signalverarbeitung angepaßte Schaltpegel umgesetzt.

Die aus "IEEE Trans. CE-31" bekannte Schaltungsanordnung ist durch Verwendung mehrerer Filter sehr aufwendig. Außerdem weisen diese Filter verhältnismäßig große Bandbreiten auf, so daß neben den Kennschwingungen von 117,5 Hz und 274,1 Hz Störungen übertragen werden, die eine eindeutige Erkennung der Übertragungsart erschweren.

Wünschenswert ist dagegen, zur Identifikation der Übertragungsart ausschließlich die Kennschwingungen zu erfassen, Schwingungen mit Frequenzen in unmittelbarer Nachbarschaft der Frequenzen der Kennschwingungen jedoch zu unterdrücken, so daß eine möglichst störungsfreie Identifikation erreicht werden kann.

Die Erfindung hat die Aufgabe, für diesen Zweck eine Schaltungsanordnung in möglichst einfacher und störsicherer Ausführung zu schaffen.

Diese Aufgabe wird erfindungsgemäß durch die Merkmale des Hauptanspruchs gelöst.

Bei der erfindungsgemäßen Schaltungsanordnung wird somit in vorteilhafter Weise die Schwierigkeit umgangen, schmalbandige Filter zur Verfügung zu stellen, die notwendigerweise einen hohen technischen Aufwand bedingen. Vielmehr wird mit einfachen Schaltungen, die lediglich ein digitales Signal mit einer Wortbreite von einem Bit verarbeiten müssen, eine beliebig schmalbandige Selektion der Kennschwingungen und damit eine beliebig störungsarme Identifikation der Übertragungsart erreicht.

Die erfindungsgemäße Schaltungsanordnung, von der vorteilhafte Ausgestaltungen in den Unteransprüchen dargestellt sind, weist lediglich drei Filter auf, an deren Güte jedoch im wesentlichen nur geringe Anforderungen gestellt werden. Die gesamte Schaltungsanordnung ist außerdem ohne Ausnahme auf einem Halbleiterkörper integrierbar., so daß externe Bauelemente entfallen. Dadurch und durch die Abgleichfreiheit ist eine sehr kostengünstige Herstellung und Montage bei zuverlässiger Funktion möglich.

Ein Ausführungsbeispiel ist in der Zeichnung dargestellt und wird im nachfolgenden näher beschrieben.
Es zeigen:
- Fig. 1: ein blockschematisches Schaltbild einer Schaltungsanordnung zum Detektieren von Kennschwingungen gemäß der Erfindung,
- Fig. 2: ein Blockschaltbild eines digitalen Phasenregelkreises und
- Fig. 3: Zeitdiagramme von Signalen an der Schaltungsanordnung nach Fig. 2.

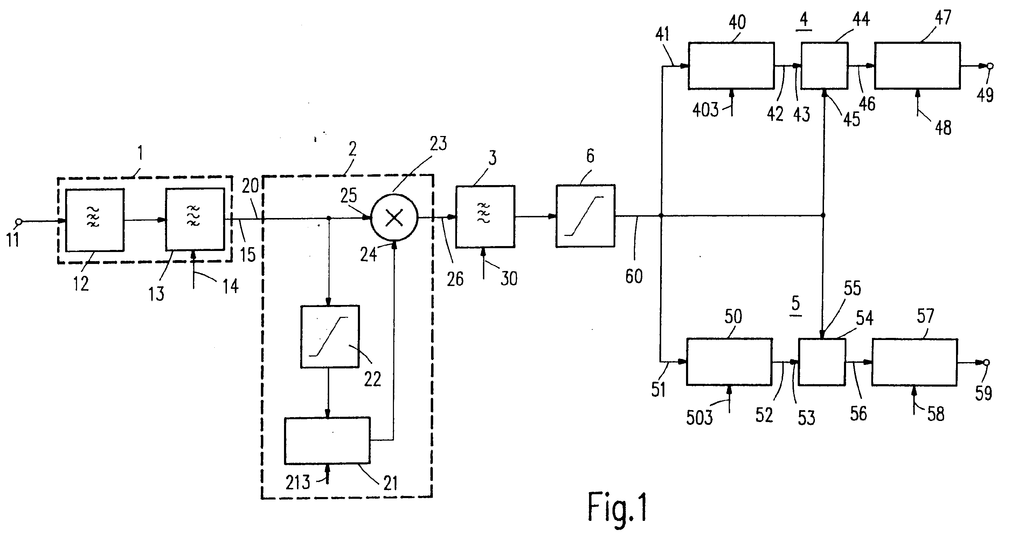

In Fig. 1 wird einer Eingangsfilterstufe 1 über einen Eingang 11 ein Fernseh-Tonsignal zugeführt, das außer einer Toninformation auch eine Pilotträgerschwingung, vorzugsweise mit einer Frequenz von 54,7 kHz, umfaßt. Je nach der Betriebsart, in der die Toninformation übertragen wird, ist die Pilotträgerschwingung mit einer Kennschwingung amplitudenmoduliert; für die Stereo-Betriebsart weist die zugehörige Kennschwingung eine Frequenz von 117,5 Hz, für die Zweiton-Betriebsart eine Frequenz von 274,1 Hz auf. Bei der Mono-Betriebsart ist die Pilotträgerschwingung unmoduliert.

Die Eingangsfilterstufe 1 umfaßt einen Hochpaß 12, dem das Fernseh-Tonsignal vom Eingang 11 zugeführt wird, und einen nachgeschalteten, vorzugsweise in Schalterkondensatortechnik ausgeführten und auf die Frequenz der Pilotträgerschwingung abgestimmten Bandpaß. Der Hochpaß 12, der vorzugsweise als kontinuierlich arbeitende Stufe ausgebildet ist, ist bezüglich seiner Grenzfrequenz derart ausgebildet, daß die Toninformation im Fernseh-Tonsignal wenigstens weitgehend unterdrückt wird und somit am Eingang des Bandpasses 13 nicht mehr auftritt. Da die Frequenz der Pilotträgerschwingung wesentlich höher ist als die höchste Frequenz in der Toninformation, ist für diesen Zweck ein Hochpaß einfacher Bauart und damit nur begrenzter Güte ausreichend.

Der Bandpaß 13 filtert aus dem verbleibenden Fernseh-Tonsignal die Pilotträgerschwingung und die ihr aufmodulierten Kennschwingungen heraus. Da die Toninformation durch den vorgeschalteten Hochpaß 12 bereits wenigstens weitgehend unterdrückt ist, werden auch an die Trennschärfe des Bandpasses 13 allenfalls mittlere Anforderungen gestellt, der sich daher auch als einfache Schaltungsanordnung ausführen läßt. Das bei einer Ausbildung des Bandpasses 13 in Schalterkondensatortechnik benötigte Taktsignal wird über einen Taktsignaleingang 14 zugeleitet. Am Ausgang 15 des Bandpasses 13, der zugleich Ausgang der Eingangsfilterstufe 1 ist, wird die mit der jeweiligen Kennschwingung amplitudenmodulierte Pilotträgerschwingung abgegeben.

In einer bevorzugten Dimensionierung weist der Bandpaß 13 eine Bandbreite von ungefähr 1 kHz auf. Damit ist einerseits gewährleistet, daß die als Seitenlinien der Pilotträgerschwingung auftretenden Kennschwingungen für den Zweitonbetrieb von 274,1 Hz wenigstens weitgehend ungedämpft durchgelassen werden, während Schwingungen mit größerem Frequenzabstand von der Pilotträgerschwingung als Störungen wirksam unterdrückt werden.

Vom Ausgang 15 der Eingangsfilterstufe 1 wird die modulierte Pilotträgerschwingung einem Eingang 20 der Amplitudendetektionsstufe 2 zugeführt. Diese umfaßt einen digitalen Phasenregelkreis 21, der auf die Pilotträgerschwingung abgestimmt ist und dem diese über einen Begrenzerverstärker 22 zum Erzeugen einer Bezugsschwingung zugeführt wird. Der Begrenzerverstärker 22 formt aus der modulierten Pilotträgerschwingung, die im wesentlichen kreisfunktionsförmigen Verlauf aufweist, ein rechteckförmiges Signal, das als Eingangssignal des digitalen Phasenregelkreises 21 dient. Der digitale Phasenregelkreis 21 erzeugt daraus in noch näher zu beschreibender Weise ein Rechtecksignal von der Frequenz der Pilotträgerschwingung, das als Bezugsschwingung in der Amplitudendetektionsstufe 2 verwendet wird. Diese Bezugsschwingung wird einer ebenfalls von der Amplitudendetektionsstufe 2 umfaßten analogen Mischstufe 23 an ihrem Bezugsschwingungseingang 24 zugeführt, während die modulierte Pilotträgerschwingung zum Mischen mit der Bezugsschwingung einem Signaleingang 25 der analogen Mischstufe 23 zugeleitet wird. Am Ausgang 26 der analogen Mischstufe 23, der gleichzeitig Ausgang der Amplitudendetektionsstufe 2 ist, steht dann als demoduliertes Signal die der Pilotträgerschwingung jeweils aufmodulierte Kennschwingung zur Verfügung. Die analoge Mischstufe ist vorzugsweise als doppelt balancierter Mischer ausgeführt.

Vom Ausgang 26 der Amplitudendetektionsstufe 2 werden die darin durch Amplituden-Synchrondemodulation gewonnenen Kennschwingungen über das Tiefpaßfilter 3 und einen Begrenzerverstärker 6 den Erkennungszweigen 4 und 5 zugeführt. Das Tiefpaßfilter 3 hat vorzugsweise eine Grenzfrequenz von 300 Hz, so daß die Kennschwingungen von 117,5 Hz bzw. 274,1 Hz wenigstens nahezu ungedämpft den Erkennungszweigen 4 bzw. 5 zugeleitet werden können, während höherfrequente Mischprodukte, Oberschwingungen und sonstige Störungen unterdrückt werden. Auch das Tiefpaßfilter 3 ist vorzugsweise in Schalterkondensatortechnik ausgeführt und kann, da an die Einhaltung der Grenzfrequenz keine hohen Anforderungen gestellt werden müssen, ebenfalls einfach aufgebaut sein. Der nachgeschaltete Begrenzerverstärker 6 dient wie der Begrenzerverstärker 22 aus der Amplitudendetektionsstufe 2 der Formung von Schaltsignalen mit digitalen Pegeln, d.h. Rechtecksignalen, aus den ihm zugeführten, im wesentlichen kreisfunktionsförmigen Analogsignalen. Dabei wird auch eine Amplitudenmodulation dieser Analogsignale unterdrückt.

Dem Tiefpaßfilter 3 wird über einen Taktsignaleingang 30 vorzugsweise das auch dem Bandpaß 13 über den Taktsignaleingang 14 zugeleitete Taktsignal zugeführt. Da jedoch im Vergleich zum Bandpaß 13 im Tiefpaßfilter 3 wesentlich niedrigere Frequenzen verarbeitet werden, kann in einer abgewandelten Ausführung dem Taktsignaleingang 30 auch ein Taktsignal niedrigerer Frequenz zugeleitet werden.

Am Ausgang 60 des Begrenzerverstärkers 6 für die Kennschwingungen steht somit je nach Betriebsart ein aus der jeweiligen Kennschwingung abgeleitetes Rechtecksignal mit einer Frequenz von 117,5 Hz bei der Stereo-Betriebsart bzw. 274,1 Hz bei der Zweiton-Betriebsart zur Weiterleitung an die Erkennungszweige 4, 5 zur Verfügung. Im Fall der Mono-Betriebsart tritt keine Kennschwingung auf. In einer Variation der eingangs genannten Signalverläufe dieser Betriebsart kann dann auch die Pilotträgerschwingung von vorzugsweise 54,7 kHz vollständig entfallen, d.h. sie braucht vom Sender nicht ausgestrahlt zu werden.

Jeder der Erkennungszweige 4 bzw. 5, die prinzipiell identisch aufgebaut, jedoch auf die unterschiedlichen Frequenzen der Kennschwingungen abgestimmt sind, enthält einen digitalen Phasenregelkreis 40 bzw. 50 mit schmalbandigem Fangbereich um die Frequenz der zu detektierenden Kennschwingung, also um 117,5 Hz beim digitalen Phasenregelkreis 40 des Stereo-Erkennungszweiges 4 und um 274,1 Hz beim digitalen Phasenregelkreis 50 des Zweiton-Erkennungszweiges 5. Jeder der digitalen Phasenregelkreise 40 bzw. 50 erhält an seinem Eingang 41 bzw. 51 die am Ausgang 60 des Begrenzerverstärkers 6 abgegebenen Signale zugeführt. Enthalten diese einen Anteil mit der Frequenz der Kennschwingung, auf die der jeweilige digitale Phasenregelkreis 40 bzw. 50 abgestimmt ist, bzw. einen Frequenzanteil im Fangbereich des digitalen Phasenregelkreises 40 bzw. 50 um die genannte Abstimmfrequenz herum, geben die digitalen Phasenregelkreise 40 bzw. 50 an ihren Ausgängen 42 bzw. 52 ein Rechtecksignal mit der Frequenz der zugeordneten Kennschwingung ab. Dieses als Bezugsschwingung bezeichnete Signal wird je einem ersten Eingang 43 bzw. 53 eines digitalen Synchrondemodulators 44 bzw. 54 zugeführt, der an seinem zweiten Eingang 45 bzw. 55 das vom Ausgang 60 des Begrenzerverstärkers 6 unverändert gelieferte Signal zugeführt erhält. Dieses Signal wird im zugehörigen Synchrondemodulator 44 bzw. 54 mit der Bezugsschwingung vom entsprechenden digitalen Phasenregelkreis 40 bzw. 50 demoduliert und danach über eine Leitung 46 bzw. 56 je einem digitalen Integrator 47 bzw. 57 zugeführt.

In einer besonders einfachen Ausführung umfassen die digitalen Synchrondemodulatoren 44, 54 je ein Exklusiv- Oder-Gatter. Dieses liefert über die Leitung 46 nur dann ein Signal mit konstantem Pegel, wenn den Eingängen 43, 45 bzw. 53, 55 der digitalen Synchrondemodulatoren 44 bzw. 54 Signale gleicher Frequenz zugeleitet werden. Dies ist jedoch nur dann der Fall, wenn die über den Ausgang 60 des Begrenzerverstärkers 6 angebotenen Schwingungen Frequenzen innerhalb des Fangbereichs des zugehörigen, digitalen Phasenregelkreises 40 bzw. 50 aufweisen.

Die digitalen Integratoren 47 bzw. 57 umfassen bevorzugt je eine Zählschaltung, denen über Zählimpulseingänge 48 bzw. 58 Zählimpulse zugeführt werden. In den digitalen Integratoren 47, 57 werden diese Zählimpulse beim Auftreten eines vorbestimmten Wertes des Ausgangssignals des zugehörigen, digitalen Synchrondemodulators 44 bzw. 54 auf den Leitungen 46 bzw. 56 über ein vorgegebenes Zeitintervall hinweg aufsummiert. Wird während oder zum Schluß des vorgegebenen Zeitintervalls in einem der Integratoren 47, 57 eine bestimmte Zählstellung erreicht oder überschritten, gibt der entsprechende Integrator 47 bzw. 57 an einem Identifikationssignalausgang 49 bzw. 59 ein Identifikationssignal ab, welches die Betriebsart kennzeichnet, in der das empfangene und verarbeitete Fernseh-Tonsignal übertragen wird. Die Zählstellung, bei der das Identifikationssignal auftritt, kann als Bruchteil der im vorgegebenen Zeitintervall maximal erreichbaren Summe der Zählimpulse festgelegt sein. Durch die Integratoren 47, 57 werden kurzzeitige Störungen auf den Leitungen 46, 56 durch Rauschen oder Schwebungen unterdrückt. Vorzugsweise beträgt der Fangbereich der digitalen Phasenregelkreise 40 bzw. 50 1 Hz, symmetrisch zu den Frequenzen der Kennschwingungen angeordnet. Durch die digitalen Integratoren 47, 57 werden diese Fangbereiche noch einmal symmetrisch um 1 Hz erweitert, so daß von den Erkennungszweigen 4 und 5 als Kennschwingungen lediglich Schwingungen in einem Frequenzbereich von 2 Hz um die Frequenz der zugehörigen Kennschwingung herum akzeptiert werden. Die digitalen Integratoren 47, 57 werden dann mit großen Zeitkonstanten von etwa einer Sekunde dimensioniert. Zeitkonstante und sogenanntes Kennungsfenster, d.h. Frequenzbereich der als Kennschwingung akzeptierten Schwingungen, sind in ihrer Dimensionierung aufeinander abgestimmt, um eine sichere Erkennung detektierter Kennschwingungen zu ermöglichen.

Die beschriebene Ausgestaltung der Erkennungszweige hat außerdem den Vorteil, daß die Kennungsfenster beliebig, auch enger, dimensioniert werden können, so daß nicht nur in das Basisband heruntergemischtes Rauschen, sondern auch Übersprechen von Bild- oder Tonsignalen unterdrückt werden kann.

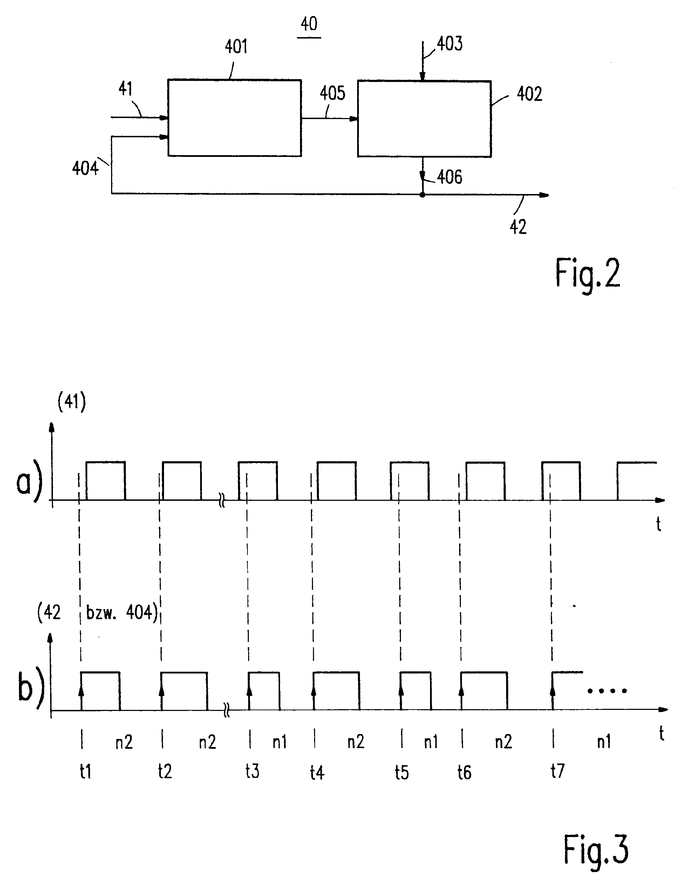

Fig. 2 zeigt ein Blockschaltbild zur Erläuterung der Funktion der digitalen Phasenregelkreise 21, 40 bzw. 50 am Beispiel des digitalen Phasenregelkreises 40. Dieser umfaßt ein Abtast- und Halteglied 401 zum Abspeichern des Wertes des dem Phasenregelkreis 40 über den Eingang 41 zugeführten Signals beim Auftreten einer Flanke in einem Steuersignal, das am Abtast- und Halteglied 401 über einen Steuereingang 404 anliegt. Im Abtast- und Halteglied 401 wird also bei jeder Flanke des Steuersignals der gerade aktuelle der beiden Signalpegel gespeichert, die das vom Begrenzerverstärker 6 gelieferte Signal annehmen kann. In Abhängigkeit von diesem, am Ausgang 405 des Abtast- und Haltegliedes 401 bis zum nächsten Abtastvorgang abgegebenen Wert wird ein zwischen zwei Divisoren umschaltbarer Frequenzteiler 402 die Frequenz einer über einen Referenzeingang 403 dem Frequenzteiler 402 zugeführten Referenzschwingung teilen. Das frequenzgeteilte Signal erscheint am Ausgang 406 des Frequenzteilers 402 und bildet einerseits das Steuersignal für den Steuereingang 404 und andererseits die Bezugsschwingung für den Ausgang 42 des digitalen Phasenregelkreises 40.

Fig. 3 zeigt im Teildiagramm a) den zeitlichen Verlauf der vom Begrenzerverstärker 6 abgegebenen, rechteckförmigen Kennschwingung, wie sie beim Vorliegen der Stereo-Betriebsart dem Eingang 41 des Phasenregelkreises 40 zugeleitet wird. Im Teildiagramm b) ist dazu die vom Phasenregelkreis 40 erzeugte Bezugsschwingung skizziert, und zwar im linken Teil des Diagramms im nicht synchronisierten Zustand des Phasenregelkreises, während im rechten Teil des Diagramms der Zustand dargestellt ist, in dem der Phasenregelkreis mit der Kennschwingung synchron läuft, d.h. auf sie eingerastet ist. Mit t ist in beiden Diagrammen die Zeit bezeichnet. Dabei sind t1 bis t7 die Zeitpunkte, zu denen im Steuersignal am Steuereingang 404 eine Flanke auftritt, d.h. vom Abtast- und Halteglied 401 der aktuelle Wert des Signals am Eingang 41 abgespeichert wird.

Zu Beginn des in den Diagrammen betrachteten Zeitraums läuft der digitale Phasenregelkreis frei, ist also nicht eingerastet. Entprechend wird im gezeigten Beispiel vom Abtast- und Halteglied 401 mehrfach ein niedriger Signalwert (Zeitpunkte t1, t2) abgespeichert. Im Frequenzteiler 402 wird dann die Frequenz der Referenzschwingung vom Referenzeingang 403 durch den größeren der beiden Divisoren, n2, dividiert. Entsprechend ist die Periodendauer des Steuersignals am Ausgang 406 größer als die Periodendauer der zugeführten Kennschwingung am Eingang 41. Die Flanken im Steuersignal, d.h. die Zeitpunkte t1, t2, verschieben sich somit allmählich zu späteren Phasenlagen des Signals am Eingang 41. Zum Zeitpunkt t3 wird dann ein Zustand erreicht, in dem die Flanke im Steuersignal am Steuereingang 404 zu einem Zeitpunkt eintrifft, in dem das Signal am Eingang 41 nicht mehr einen niedrigen, sondern inzwischen einen hohen Wert angenommen hat. Über den Ausgang 405 steuert dieser Wert den Frequenzteiler 402 nun derart um, daß die Referenzschwingung vom Referenzeingang 403 durch den kleineren der beiden Divisoren, n1, geteilt wird. Entsprechend verkürzt sich die Periodendauer des Steuersignals bis zu seiner nächsten Flanke, bei der wiederum der Wert des Signals am Eingang 41 abgetastet wird. Dieser Zeitpunkt t4 liegt im Diagramm nach Fig. 3 wieder so, daß dort im Signal am Eingang 41 ein niedriger Wert abgetastet wird. Dadurch wird erneut die Referenzschwingung durch den Divisor n2 dividiert. Im eingerasteten Zustand wechseln nun von einer Flanke im Steuersignal zur nächsten die abgespeicherten Werte einander kontinuierlich ab, so daß die Frequenz der Referenzschwingung zwischen je zwei aufeinanderfolgenden Flanken im Steuersignal abwechselnd durch den ersten und durch den zweiten Divisor n1 bzw. n2 geteilt wird. Dieser eingerastete Zustand kann jedoch nur erreicht werden, wenn die Frequenz des Signals am Eingang 41 zwischen den beiden durch die Frequenz der Referenzschwingung und die Werte der Divisoren n1 und n2 festgelegten Frequenzwerten liegt, die die Grenzen des Fangbereichs bilden. Durch entsprechende Wahl der Frequenz der Referenzschwingung und der Werte der Divisoren n1, n2 kann somit der Fangbereich des digitalen Phasenregelkreises 40 beliebig gewählt werden.

Entsprechend dem Referenzeingang 403 des digitalen Phasenregelkreises 40 weisen auch die Phasenregelkreise 21 und 50 Referenzeingänge 213 bzw. 503 auf. Den Referenzeingängen 403, 503 bzw. 213 wird bevorzugt dieselbe Referenzschwingung oder ein aus derselben Referenzschwingung abgeleitetes Signal zugeführt. Weiterhin werden vorteilhaft aus der Referenzschwingung Taktsignale abgeleitet, die dem Bandpaß 13 sowie dem Tiefpaßfilter 3 am zugehörigen Taktsignaleingang 14 bzw. 30 zugeleitet werden. Darüber hinaus können auch die Zählimpulse an den Zählimpulseingängen 48, 58 aus der Referenzschwingung abgeleitet sein. Dann ist insgesamt für die Schaltungsanordnung nach Fig. 1 nur ein einziges Frequenznormal erforderlich, so daß die gesamte, auf einem Halbleiterkristall integrierbare Anordnung als einziges externes Bauelement lediglich mit einem Schwingquarz gekoppelt ist.

Bei der vorliegenden Anordnung wird grundsätzlich der Fangbereich des digitalen Phasenregelkreises 21 in der Amplitudendetektionsstufe 2 ebenfalls so schmal wie möglich ausgeführt. Der Fangbereich wird beispielsweise zu etwa 300 Hz gewählt. Er kann bevorzugt gerade so breit ausgeführt sein, daß auch Schwankungen in der Frequenz der Pilotträgerschwingung, die durch bestimmte Leitungsunterbrechungen in die Fernseh-Tonsignale liefernden Sendeanlagen auftreten können, noch nicht zu einem Ausfall der beschriebenen Betriebsartenerkennung führen.

Anstelle der in Fig. 1 dargestellten, parallel angeordneten Erkennungszweige 4, 5 kann auch lediglich ein einziger Erkennungszweig eingesetzt werden, der auf die Frequenzen der unterschiedlichen Kennschwingungen abstimmbar ist und im Betrieb laufend zyklisch im Zeitmultiplex nacheinander auf alle Kennschwingungen eingestellt wird, um zu detektieren, ob eine davon vorliegt. Es ist dann dafür jedoch eine entsprechende Steuerschaltung vorzusehen, und die Zeiträume, die im Mittel zur Erkennung einer bestimmten Betriebsart benötigt werden, verlängern sich. Wegen des besonders einfachen Aufbaues der Erkennungszweige 4,5 nach der vorliegenden Erfindung ist daher die vorliegende Anordnung gegenüber einer im Zeitmultiplex betriebenen kaum aufwendiger.

## Patentansprüche

1. Schaltungsanordnung zum Detektieren von Kennschwingungen, mit denen eine Pilotträgerschwingung in einem Fernseh-Tonsignal amplitudenmoduliert ist, mit einer Eingangsfilterstufe (1) zum Ausfiltern eines vorgegebenen Frequenzbandes um die Frequenz der Pilotträgerschwingung, einer Amplitudendetektionsstufe (2) zum Demodulieren der modulierten Pilotträgerschwingung, einem Tiefpaßfilter (3) zum Unterdrücken hochfrequenter Signalanteile am Ausgang (26) der Amplitudendetektionsstufe (2) sowie je einem dem Tiefpaßfilter (3) nachgeschalteten Erkennungszweig (4 bzw. 5) für jede Kennschwingung, wobei jeder Erkennungszweig einen Phasenregelkreis umfaßt,
dadurch gekennzeichnet, daß zwischen dem Tiefpaßfilter (3) und den Erkennungszweigen (4, 5) ein Begrenzerverstärker (6) angeordnet ist, daß die Phasenregelkreise als digitale Phasenkreise (40 bzw. 50) mit schmalbandigem Fangbereich um die Frequenz der zu detektierenden Kennschwingung ausgebildet sind zum Erzeugen einer Bezugsschwingung aus den Signalen am Ausgang (26) der Amplitudendetektionsstufe (2), und daß jeder Erkennungszweig (4 bzw. 5) einen digitalen Synchrondemodulator (44 bzw. 54) zum Demodulieren des vom Begrenzerverstärker (6) gelieferten Signals mit der Bezugsschwingung sowie einen digitalen Integrator (47 bzw. 57) zum Aufsummieren von Zählimpulsen beim Auftreten eines vorbestimmten Wertes des Ausgangssignals des digitalen Synchrondemodulators (44 bzw. 54) über ein vorgegebenes Zeitintervall und zur Abgabe eines von der erreichten Summe der Zählimpulse abhängigen Identifikationssignals umfaßt.

2. Schaltungsanordnung nach Anspruch 1,
dadurch gekennzeichnet, daß die Amplitudendetektionsstufe (2) einen weiteren digitalen Phasenregelkreis (21) umfaßt, der auf die Pilotträgerschwingung abgestimmt ist und dem diese über einen weiteren Begrenzerverstärker (22) zum Erzeugen einer weiteren Bezugsschwingung zugeführt wird, sowie eine analoge Mischstufe (23) zum Mischen der modulierten Pilotträgerschwingung mit der weiteren Bezugsschwingung.

3. Schaltungsanordnung nach Anspruch 1 oder 2,
dadurch gekennzeichnet, daß die Eingangsfilterstufe (1) einen Hochpaß (12) und einen nachgeschalteten, in Schalterkondensatortechnik ausgeführten und auf die Frequenz der Pilotträgerschwingung abgestimmten Bandpaß (13) umfaßt.

4. Schaltungsanordnung nach Anspruch 1, 2 oder 3,
dadurch gekennzeichnet, daß jeder digitale Phasenregelkreis (21, 40, 50) ein Abtast- und Halteglied (401) umfaßt zum Abspeichern des Wertes des dem Phasenregelkreis (21, 40, 50) zugeführten Signals beim Auftreten einer Flanke in einem Steuersignal, und daß ein je nach abgespeichertem Wert zwischen zwei Divisoren (n1, n2) umschaltbarer Frequenzteiler vorgesehen ist zum Teilen der Frequenz einer Referenzschwingung, wobei das frequenzgeteilte Signal sowohl das Steuersignal als auch die Bezugsschwingung bildet.

5. Schaltungsanordnung nach einem der vorhergehenden Ansprüche,
dadurch gekennzeichnet, daß der digitale Synchrondemodulator (44 bzw. 54) ein Exclusiv-Oder-Gatter umfaßt.

6. Schaltungsanordnung nach Anspruch 4 oder nach Anspruch 5, in Verbindung mit Anspruch 4,
dadurch gekennzeichnet, daß der digitale Integrator (47 bzw. 57) eine Zählschaltung umfaßt und die Zählimpulse aus der Referenzschwingung abgeleitet werden, und daß das Identifikationssignal bei Erreichen eines vorgegebenen Bruchteils der im vorgegebenen Zeitintervall maximal erreichbaren Summe der Zählimpulse auftritt.

7. Schaltungsanordnung nach Anspruch 4, nach Anspruch 5 in Verbindung mit Anspruch 4 oder nach Anspruch 6,
dadurch gekennzeichnet, daß die Referenzschwingung auch dem Bandpaß (13) und dem in Schalterkondensatortechnik ausgeführten Tiefpaßfilter (3) als Taktsignal zugeleitet wird.

## Claims

1. A circuit arrangement for the detection of identification signals with which a pilot carrier in a television signal is amplitude-modulated, the arrangement comprising an input-filter stage (1) for extracting a given frequency band around the frequency of the pilot carrier, an amplitude detection stage (2) for demodulating the modulated pilot carrier, a low-pass filter (3) for attenuating high-frequency signal components at the output (26) of the amplitude detection stage (2) and, arranged after the low-pass filter (3), an identification branch (4 and 5, respectively) for each identification signal, each identification branch comprising a phase-locked loop,
characterised in that a limiting amplifier (6) is arranged between the low-pass filter (3) and the identification branches (4, 5), in that the phase-locked loops are constructed as digital phase-locked loops (40 and 50, respectively) having a narrow-banded lock-in range around the frequency of the identification signal to be detected, for deriving a reference signal from the signals at the output (26) of the amplitude detection stage (2), and in that each identification branch (4 and 5, respectively) comprises a digital synchronous detector (44 and 55, respectively), for demodulating the signal supplied by limiting amplifier (6) with the reference signal, and a digital integrator (47 and 57, respectively) for the summation of the counting pulses in the case of the occurrence of a given value of the output signal of the digital synchronous demodulator (44 and 54, respectively) over a given time interval and for supplying a recognition signal which depends upon the obtained sum of the counting pulses.

2. A circuit arrangement as claimed in Claim 1,
characterised in that the amplitude detection stage (2) comprises a further digital phase-locked loop (21), which is tuned to the pilot carrier and which receives said pilot carrier via a further limiting amplifier (22) in order to generate a further reference signal, and an analog mixer stage (23) for mixing the modulated pilot carrier with the further reference signal.

3. A circuit arrangement as claimed in Claim 1 or 2,
characterised in that the input-filter stage (1) comprises a high-pass filter (12) followed by a band-pass filter (13) constructed as a switched-capacitor filter and tuned to the frequency of the pilot carrier.

4. A circuit arrangement as claimed in Claim 1, 2 or 3,
characterised in that each digital phase-locked loop (21, 40, 50) comprises a sample-and-hold element (401) for storing the value of the signal applied to the phase-locked loop (21, 40, 50) when an edge appears in a control signal, and in that there is provided a frequency divider which is switchable between two divisors (n1, n2) in dependence upon the value stored, for dividing the frequency of a reference signal, the frequency-divided signal forming both the control signal and the reference signal.

5. A circuit arrangement as claimed in any one of the preceding Claims,
characterised in that the digital synchronous demodulator (44 and 45, respectively) comprises an exclusive-or gate.

6. A circuit arrangement as claimed in Claim 4 or as claimed in Claim 5 when appendant to Claim 4,
characterised in that the digital integrator (47 and 57, respectively) comprises a counting circuit and the counting pulses are derived from the reference signal, and in that the recognition signal appears when a given fraction of the maximum attainable sum of the counting pulses in the given time interval is reached.

7. A circuit arrangement as claimed in Claim 4, as claimed in Claim 5 when appendant to Claim 4, or as claimed in Claim 6,
characterised in that the reference signal is also applied to the band-pass filter (3) and to the switched-capacitor low-pass filter (3) as a clock signal.

## Revendications

1. Montage de circuit pour la détection d'oscillations caractéristiques par lesquelles une oscillation de porteuse pilote d'un signal audio de télévision est modulée en amplitude, comportant un étage de filtrage d'entrée (1) pour extraire une bande de fréquence prédéterminée à la fréquence de l'oscillation de la porteuse pilote, un étage de détection d'amplitude (2) pour démoduler l'oscillation de la porteuse pilote modulée, un filtre passe-bas (3) pour supprimer des fractions de signaux de haute fréquence à la sortie (26) de l'étage de détection d'amplitude (2) ainsi que, respectivement, une branche d'identification (4 ou 5) montée en aval du filtre passe-bas (3) pour chaque oscillation caractéristique, chaque branche d'identification comprenant un circuit d'asservissement de phase, caractérisé en ce qu'entre le filtre passe-bas (3) et les branches d'identification (4, 5) est agencé un amplificateur limiteur (6), que les circuits d'asservissement de phase se présentent sous la forme de circuits de phase numériques (40 ou 50) avec une plage de capture à bande étroite à la fréquence de l'oscillation caractéristique à détecter pour produire une oscillation de référence à partir des signaux apparaissant à la sortie (26) de l'étage de détection d'amplitude (2), et que chaque branche d'identification (4 ou 5) comporte un démodulateur synchrone numérique (44 ou 54) pour démoduler le signal délivré par l'amplificateur limiteur (6) avec l'oscillation de référence ainsi qu'un intégrateur numérique (47 ou 57) pour sommer des impulsions de comptage à l'apparition d'une valeur prédéterminée du signal de sortie du démodulateur synchrone numérique (44 ou 54) sur un intervalle de temps prédéterminé et pour délivrer un signal d'identification dépendant de la somme des impulsions de comptage atteintes.

2. Montage de circuit selon la revendication 1, caractérisé en ce que l'étage de détection d'amplitude (2) comprend un autre circuit d'asservissement de phase numérique (21), qui est réglé sur l'oscillation de la porteuse pilote et auquel celle-ci est acheminée via un autre amplificateur limiteur (22) pour produire une autre oscillation de référence, ainsi qu'un étage de mélange analogique (23) pour mélanger l'oscillation de la porteuse pilote modulée avec l'autre oscillation de référence.

3. Montage de circuit selon la revendication 1 ou 2, caractérisé en ce que l'étage de filtrage d'entrée (1) comprend un filtre passe-haut (12) suivi d'un filtre passe-bande (13) réalisé selon la technique des condensateurs de commutation et réglé sur la fréquence de l'oscillation de la porteuse pilote.

4. Montage de circuit selon la revendication 1, 2 ou 3, caractérisé en ce que chaque circuit d'asservissement de phase numérique (21, 40, 50) comprend un élément échantillonneur-bloqueur (401) pour stocker la valeur du signal acheminé au circuit d'asservissement de phase (21, 40, 50), lors de l'apparition d'un flanc dans un signal de commande, et en ce qu'il est prévu un diviseur de fréquence qui peut être commuté, respectivement en fonction de la valeur stockée, entre deux diviseurs (n1, n2) pour diviser la fréquence d'une oscillation de référence, le signal à fréquence divisée formant autant le signal de commande que l'oscillation de référence.

5. Montage de circuit selon l'une quelconque des revendications précédentes, caractérisé en ce que le démodulateur synchrone numérique (44 ou 54) contient une porte OU exclusif.

6. Montage de circuit selon la revendication 4 ou selon la revendication 5, en liaison avec la revendication 4, caractérisé en ce que l'intégrateur numérique (47 ou 57) contient un circuit de comptage et les impulsions de comptage sont dérivées de l'oscillation de référence, et que le signal d'identification apparaît lorsqu'est atteinte une fraction prédéterminée de la somme des impulsions de comptage que l'on peut obtenir au maximum dans l'intervalle de temps prédéterminé.

7. Montage de circuit selon la revendication 4, selon la revendication 5 en liaison avec la revendication 4 ou selon la revendication 6, caractérisé en ce que l'oscillation de référence est également acheminée au filtre passe-bande (13) et au filtre passe-bas (3) réalisé en technique des condensateurs de commutation, sous la forme d'un signal de cadence.
